(19) Europäisches Patentamt
European Patent Office
Office européen des brevets

(11) **EP 4 682 677 A1**

(12) **EUROPEAN PATENT APPLICATION**

(43) Date of publication:
**21.01.2026 Bulletin 2026/04**

(21) Application number: **25190451.2**

(22) Date of filing: **18.07.2025**

(51) International Patent Classification (IPC):
***G06F 1/324*** (2019.01)　　***G06F 1/3234*** (2019.01)
***G06F 1/3296*** (2019.01)

(52) Cooperative Patent Classification (CPC):
**G06F 1/3296; G06F 1/324; G06F 1/3243**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **19.07.2024　CN 202410974971**

(71) Applicant: **Bitdeer Semiconductor Technology PTE. LTD.**
**049514 Singapore (SG)**

(72) Inventors:
• **CHEN, XIN**
　**049514 SINGAPORE (SG)**
• **XU, SONG**
　**049514 SINGAPORE (SG)**
• **ZHANG, WEI**
　**049514 SINGAPORE (SG)**

(74) Representative: **Metida**
**Gyneju str. 16**
**01109 Vilnius (LT)**

(54) **FREQUENCY SCANNING METHOD AND APPARATUS FOR HASH BOARD, AND DIGITAL CREDENTIAL PROCESSING DEVICE**

(57)　A frequency sweeping method for a hash board includes: applying an initial voltage to the hash board to power on the hash board, and controlling chips in all chip domains to operate at a target frequency; switching each of the chips to a SPAT mode while maintaining the chip at the target frequency, and progressively reducing a voltage of the hash board; calculating a nonce response rate of the chip; and in a case where the nonce response rate of the chip is less than a predetermined threshold, determining a previous voltage level corresponding to the nonce response rate as a limit voltage of the hash board under the target frequency; maintaining each of the chips at the limit voltage, and calculating a frequency adjustment function of the hash board.

S100　Applying an initial voltage to the hash board to power on the hash board, and controlling chips in all chip domains to operate at a target frequency

S200　Switching each of the chips to a SPAT mode while maintaining the chip at the target frequency, and progressively reducing a voltage of the hash board; calculating a nonce response rate of the chip; and in a case where the nonce response rate of the chip is less than a predetermined threshold, determining a previous voltage level corresponding to the nonce response rate as a limit voltage of the hash board under the target frequency

S300　Maintaining each of the chips at the limit voltage, and calculating a frequency adjustment function of the hash board, such that operating frequencies of the chip domains from an air inlet to an air outlet of the hash board linearly increase from low to high

S400　Setting the operating frequency of each of the chip domains based on the frequency adjustment function, such that the chip domain at the air inlet has a lowest frequency, the chip domain at the air outlet has a highest frequency, and an average operating frequency of the entire hash board is equal to the target frequency

FIG. 1

## Description

## TECHNICAL FIELD

The present disclosure relates to the technical field of blockchain device manufacturing, and in particular, relates to a frequency sweeping method and apparatus for a hash board, and a digital credential processing device.

## BACKGROUND

With the advancement of information technology, the demand for the computing power of chips used for data processing in fields such as Artificial Intelligence (AI) and digital credential processing is rapidly increasing.

At present, in some apparatuses dedicated to data processing, such as hash boards, a plurality of chips are employed in a processor to perform calculations in order to enhance the speed of data processing. Generally, frequency sweeping is performed on the plurality of chips to determine a uniform operating frequency for all of chips. However, the performance of a chip is also influenced by temperature; temperatures that are either too high or too low are detrimental to the utilization of the computing power. For example, on a hash board, the temperature progressively rises from an air inlet to an air outlet. Where all chips operate at the same frequency, this would lead to problems such as resource waste and imbalanced performance of the chips on the hash board.

## SUMMARY

Accordingly, the present disclosure is mainly intended to provide a frequency sweeping method and apparatus for a hash board, which enables operating frequencies of all chip domains of the hash board to exhibit a descending linear relationship, thereby improving the operational balance of the chips in their actual working environment.

To achieve the above objective, the present disclosure employs the following technical solutions:

Some embodiments of the present disclosure provide a frequency sweeping method for a hash board. The method includes: S100, applying an initial voltage to the hash board to power on the hash board, and controlling chips in all chip domains to operate at a target frequency; S200, switching each of the chips to a SPAT mode while maintaining the chip at the target frequency, and progressively reducing a voltage of the hash board; calculating a nonce response rate of the chip; and in a case where the nonce response rate of the chip is less than a predetermined threshold, determining a previous voltage level corresponding to the nonce response rate as a limit voltage of the hash board under the target frequency; S300, maintaining each of the chips at the limit voltage, and calculating a frequency adjustment function of the hash board, such that operating frequencies of the chip domains from an air inlet to an air outlet of the hash board linearly increase from low to high; and S400, setting the operating frequency of each of the chip domains based on the frequency adjustment function, such that the chip domain at the air inlet has a lowest frequency, the chip domain at the air outlet has a highest frequency, and an average operating frequency of the entire hash board is equal to the target frequency.

In some embodiments, the target frequency is a product of an initial voltage of each of the chip domains and a number of the chip domains.

In some embodiments, the voltage of the hash board is progressively decreased based on a first predetermined step and a first predetermined period.

In some embodiments, the frequency adjustment function is:

$f_n = a*n + b$ wherein $n$ represents a serial number of the chip domain, $n = 1, 2 ......N$, N being a number of the chip domains; $f_n$ represents the operating frequency of an $n^{th}$

$$a = \frac{f_T - b}{N/4}$$

chip domain; , $f_T$ being the target frequency; and an initial value of $b$ is $f_T$; the value of $b$ is progressively decreased based on a second predetermined step; each of the chips is switched to the SPAT mode; the nonce response rate of each of the chips is calculated and a final value of $b$ is obtained until the nonce response rate is less than the predetermined threshold or the value of $b$ is not less than a minimum operating frequency of the chip and is minimal; and in a case where the nonce response rate is less than the predetermined threshold, the value of $b$ is a previous-level value of $b$ of the value of $b$ corresponding to the nonce response rate that is less than the predetermined threshold.

Some embodiments of the present disclosure further provide a computer-readable storage medium, storing one or more programs; wherein the one or more programs, when loaded and run by a processor, cause the processor to perform the frequency sweeping method as described above.

Some embodiments of the present disclosure further provide a hash board. The hash board is configured to implement setting of operating frequencies of chips in the hash board by using the frequency sweeping method as described above.

Some embodiments of the present disclosure further provide a digital credential processing device. The digital credential processing device includes the hash board as described above.

Some embodiments of the present disclosure further provide a frequency sweeping apparatus for a hash board. The apparatus includes: a target frequency setting module, a voltage adjusting module, a frequency adjustment function calculating module, and a frequency setting module; wherein the target frequency setting module is configured to apply an initial voltage to the hash board to power on the hash board, and control chips in all chip domains to operate at a target frequency; the voltage adjusting module is configured to switch each of the chips to a SPAT mode while maintaining the chip at the target frequency, and progressively reduce a voltage of the hash board; calculate a nonce response rate of the chip; and in a case where the nonce response rate of the chip is less than a predetermined threshold, determine a previous voltage level corresponding to the nonce response rate as a limit voltage of the hash board under the target frequency; the frequency adjustment function calculating module is configured to maintain each of the chips at the limit voltage, and calculate a frequency adjustment function of the hash board, such that operating frequencies of the chip domains from an air inlet to an air outlet of the hash board linearly increase from low to high; and the frequency setting module is configured to set the operating frequency of each of the chip domains based on the frequency adjustment function, such that the chip domain at the air inlet has a lowest frequency, the chip domain at the air outlet has a highest frequency, and an average operating frequency of the entire hash board is equal to the target frequency.

In some embodiments, the voltage adjusting module is configured to progressively decrease the voltage of the hash board based on a first predetermined step and a first predetermined period.

In some embodiments, the frequency adjustment function is: $f_n = a*n + b$ wherein $n$ represents a serial number of the chip domain, $n = 1, 2 \ldots \ldots N$, N being a number of the chip domains; $f_n$ represents the operating

$$a = \frac{f_T - b}{N/4}$$

frequency of an $n^{th}$ chip domain; , $f_T$ being the target frequency; and an initial value of $b$ is $f_T$; the value of $b$ is progressively decreased based on a second predetermined step; each of the chips is switched to the SPAT mode; the nonce response rate of each of the chips is calculated and a final value of $b$ is obtained until the nonce response rate is less than the predetermined threshold or the value of $b$ is not less than a minimum operating frequency of the chip and is minimal; and in a case where the nonce response rate is less than the predetermined threshold, the value of $b$ is a previous-level value of $b$ of the value of $b$ corresponding to the nonce response rate that is less than the predetermined threshold.

Some embodiments of the present disclosure further provide a digital credential processing device. The digital credential processing device includes the frequency sweeping apparatus as described above.

The present disclosure takes into comprehensive consideration factors such as the voltage of the hash board and the operating temperatures of chip domains at different positions, and proposes a novel frequency sweeping method for a hash board. According to the method, upon power on, the hash board is first quickly adjusted to a target frequency. At this target frequency, the hash board first undergoes voltage regulation to acquire a limit voltage, and then undergoes frequency regulation, thereby accomplishing frequency sweeping for the hash board. Ultimately, the operating frequencies of all chip domains of the hash board exhibit a descending linear relationship, which improves the operational balance of the chips in their actual working environment.

Other beneficial effects of the present disclosure are described in retail with reference to specific technical features and technical solutions in the specific embodiments. A person skilled in the art may understand the beneficial effects achieved by these technical features and technical solutions through description of these technical features and technical solutions.

## BRIEF DESCRIPTION OF THE DRAWINGS

Some embodiments of a frequency sweeping method and apparatus for a hash board are described with reference to accompanying drawings hereinafter.

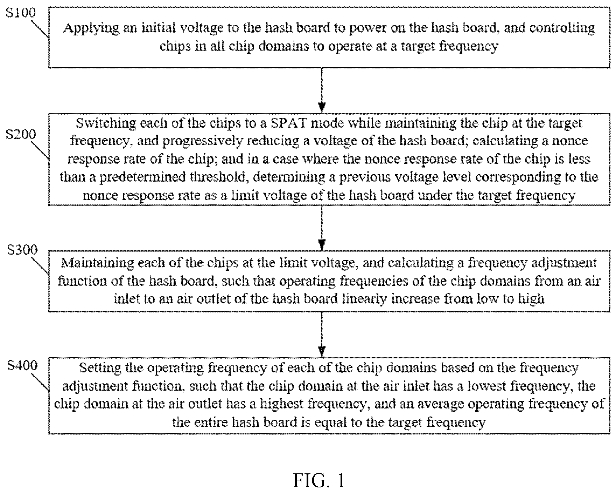

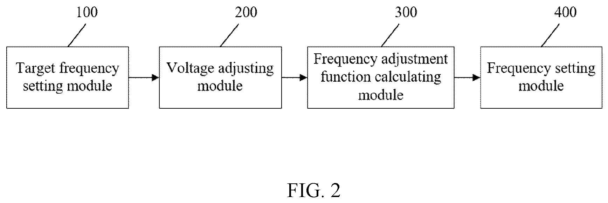

FIG. 1 is a schematic flowchart of a frequency sweeping method for a hash board according to some embodiments of the present disclosure; and FIG. 2 is a schematic flowchart of a frequency sweeping apparatus for a hash board according to some embodiments of the present disclosure.

## DETAILED DESCRIPTION

The present disclosure is described with reference to some exemplary embodiments. However, the present disclosure is not limited to these exemplary embodiments. In the detailed description of the present disclosure, specific details are set forth. To avoid unnecessarily obscuring the substance of the present disclosure, well-known methods, procedures, processes, and components have not been described in detail.

Furthermore, it should be understood by persons of ordinary skill in the art that the drawings provided herein are for illustrative purposes only and are not necessarily drawn to scale.

Unless the context clearly requires otherwise, throughout this specification and the claims, the words "comprise," "contain," and the like are to be construed in an inclusive sense, as opposed to an exclusive or exhaustive sense, that is, in the sense of "including, but not limited to."

It should be noted that terms such as "first," "second," and the like are merely used for illustration purpose during the description of the present disclosure, and shall not be understood as indicating or implying relative importance. In addition, in the description of the present disclosure, the term "a plurality of," "more," or "a plurality of" refers to at least two unless otherwise specified.

FIG. 1 is a schematic flowchart of a frequency sweeping method for a hash board according to some embodiments of the present disclosure. The method includes the following steps.

In S 100, an initial voltage is applied to the hash board to power on the hash board, and chips in all chip domains are controlled to operate at a target frequency. During setting of the target frequency for the hash board, the target frequency may not be directly set . Instead, the frequency needs to be adjusted incrementally, starting from a low frequency and progressively increasing to the target frequency. In the technical solution, compared to conventional technologies, this incremental adjustment process is relatively fast, as the waiting time at each adjustment frequency point is shorter. This, in turn, optimizes the duration of the entire frequency sweeping process.

In S200, each of the chips is switched to a SPAT mode while the chip is maintained as operating at the target frequency, and a voltage of the hash board is progressively reduced; a nonce response rate of the chip is calculated; and in a case where the nonce response rate of the chip is less than a predetermined threshold, a previous voltage level corresponding to the nonce response rate is determined as a limit voltage of the hash board under the target frequency.

In S300, each of the chips is maintained at the limit voltage, and a frequency adjustment function of the hash board is calculated, such that operating frequencies of the chip domains from an air inlet to an air outlet of the hash board linearly increase from low to high.

In S400, the operating frequency of each of the chip domains is set based on the frequency adjustment function, such that the chip domain at the air inlet has a lowest frequency, the chip domain at the air outlet has a highest frequency, and an average operating frequency of the entire hash board is equal to the target frequency.

The present disclosure takes into comprehensive consideration factors such as the voltage of the hash board and the operating temperatures of chip domains at different positions, and proposes a novel frequency sweeping method for a hash board. According to the method, upon power on, the hash board is first quickly adjusted to a target frequency. At this target frequency, the hash board first undergoes voltage regulation to acquire a limit voltage, and then undergoes frequency regulation, thereby accomplishing frequency sweeping for the hash board. Ultimately, the operating frequencies of all chip domains of the hash board exhibit a descending linear relationship, which improves the operational balance of the chips in their actual working environment.

In some embodiments, the target frequency is a product of an initial voltage of each of the chip domains and a number of the chip domains. As an example, given a hash board with N chip domains where the initial voltage for each chip domain is 0.29 V, the initial voltage of the hash board may be set as the product of 0.29 and N, which is 0.29*N (V).

In some embodiments, the voltage of the hash board is progressively decreased based on a first predetermined step and a first predetermined period. In a specific embodiment, while the target frequency is kept constant, the voltage is incrementally decreased. This is performed with a first predetermined step of 0.2 V at a first predetermined period of 30s. Concurrently, the chips are switched to the SPAT mode, and their nonce response rates are calculated as a feedback result. This process continues until the nonce response rate falls below a predetermined threshold. At that point, the limit voltage of the hash board at the target frequency is determined. The limit voltage is determined as a voltage level of the step immediately preceding a voltage level at which the nonce response rate falls below the preset threshold.

In a specific embodiment, the control module of the hash board may broadcast a SPAT command to all chips, instructing the chips to enter a SPAT mode. In the SPAT mode, the chips perform a self-test by running an internal pattern (i.e., a computational algorithm). This pattern covers all channels/pipelines within the chips. The nonce response rate is then tracked. When this nonce response rate is less than the predetermined threshold, the limit voltage of the hash board at the target frequency is determined, and the nonce response rate may be returned to the control module.

For example, a chip has 10 cores and each core has 16 channels, then each chip should report 10*16=160 nonces. In a case where the number of received nonces (representing the nonce response rate) is less than 158 (i.e., 99%), it is considered that the nonce response rate is less than the preset threshold.

In this technical solution, upon completion of the voltage adjustment, the process proceeds to frequency adjustment. Typically, the temperature of the chips on the hash board exhibits a progressively increasing trend from the air inlet to the air outlet, and consequently, the optimal operating frequency point also follows a rising trend. Under these circumstances, taking into account temperature distribution, the frequencies of the corresponding chips are individually adjusted. This is done with the objective of setting a lower frequency for chips near the air inlet and a higher frequency for chips near the air outlet, while ensuring that the average frequency remains consistent with the target frequency. This thereby achieves operational balance for the chips of the hash board.

In some embodiments, the frequency adjustment function is: $f_n = a*n + b$ wherein $n$ represents a serial number of the chip domain, $n$ = 1, 2 ... ...N, N being a number of the chip domains; $f_n$ represents the operating

$$a = \frac{f_T - b}{N/4}$$

frequency of an $n^{th}$ chip domain;                          , $f_T$ being the target frequency; and an initial value of $b$ is $f_T$; the value of $b$ is progressively decreased based on a second predetermined step; each of the chips is switched to the SPAT mode; the nonce response rate of each of the chips is calculated and a final value of b is obtained until the nonce response rate is less than the predetermined threshold or the value of b is not less than a minimum operating frequency of the chip and is minimal; and in a case where the nonce response rate is less than the predetermined threshold, the value of b is a previous-level value of b of the value of b corresponding to the nonce response rate that is less than the predetermined threshold.

For example, the matrix of chip domains on a high-performance hash board is deployed in a direction from the air inlet to the air outlet and then back to the air inlet (i.e., a serpentine layout), this means there is a first row of chip domains extending from the air inlet to the air outlet, followed by a second row of chip domains extending from the air outlet back to the air inlet. It is assumed the total number of chip domains is N. The chip domains from the inlet to the outlet (the first row) are subjected to frequency sweeping according to the technical solution of the present disclosure. The operating frequencies for the chip domains from the outlet back to the inlet (the second row) may be configured to mirror those of the chip domains from the air inlet to the air outlet. That is, the frequency setting for the chip domains in the second row, when viewed in the direction from the air inlet to the air outlet, is identical to the frequency setting of the chip domains in the first row. In a case where a third row of chip domains exists, also extending from the inlet to the outlet, the frequency setting thereof may be identical to that of the first row, and so on.

Some embodiments of the present disclosure further provide a computer-readable storage medium, storing one or more executable programs; wherein the one or more executable programs, when loaded and run by a processor, cause the processor to perform the frequency sweeping method as described above.

Some embodiments of the present disclosure further provide a hash board. The hash board is configured to implement setting of operating frequencies of chips in the hash board by using the frequency sweeping method as described above.

Some embodiments of the present disclosure further provide a digital credential processing device. The digital credential processing device includes the hash board as described above.

Some embodiments of the present disclosure further provide a frequency sweeping apparatus for a hash board. The frequency sweeping apparatus includes: a target frequency setting module 100, a voltage adjusting module 200, a frequency adjustment function calculating module 300, and a frequency setting module 400. The target frequency setting module 100 is configured to apply an initial voltage to the hash board to power on the hash board, and control chips in all chip domains to operate at a target frequency. The voltage adjusting module 200 is configured to switch each of the chips to a SPAT mode while maintaining the chip at the target frequency, and progressively reduce a voltage of the hash board; calculate a nonce response rate of the chip; and in a case where the nonce response rate of the chip is less than a predetermined threshold, determine a previous voltage level corresponding to the nonce response rate as a limit voltage of the hash board under the target frequency. The frequency adjustment function calculating module 300 is configured to maintain each of the chips at the limit voltage, and calculate a frequency adjustment function of the hash board, such that operating frequencies of the chip domains from an air inlet to an air outlet of the hash board linearly increase from low to high. The frequency setting module 400 is configured to set the operating frequency of each of the chip domains based on the frequency adjustment function, such that the chip domain at the air inlet has a lowest frequency, the chip domain at the air outlet has a highest frequency, and an average operating frequency of the entire hash board is equal to the target frequency.

In some embodiments, the voltage adjusting module 200 is configured to progressively decrease the voltage of the hash board based on a first predetermined step and a first predetermined period.

In some embodiments, the frequency adjustment function is: $f_n = a*n + b$ wherein $n$ represents a serial number of the chip domain, $n$ = 1, 2 ... ...N, N being a number of the chip domains; $f_n$ represents the operating

$$a = \frac{f_T - b}{N/4}$$

frequency of an $n^{th}$ chip domain; , $f_T$ being the target frequency; and an initial value of b is $f_T$; the value of b is progressively decreased based on a second predetermined step; each of the chips is switched to the SPAT mode; the nonce response rate of each of the chips is calculated and a final value of b is obtained until the nonce response rate is less than the predetermined threshold or the value of b is not less than a minimum operating frequency of the chip and is minimal; and in a case where the nonce response rate is less than the predetermined threshold, the value of b is a previous-level value of b of the value of b corresponding to the nonce response rate that is less than the predetermined threshold.

Some embodiments of the present disclosure further provide a digital credential processing device. The digital credential processing device includes the frequency sweeping apparatus as described above.

A person skilled in the art would understand that the above technical solutions may be freely combined and superimposed as long as no conflicts exist. The flowcharts and block diagrams in the accompanying drawings illustrate possibly practicable system architecture, functions and operations of the system, method and computer program product according to various embodiments of the present disclosure. Based on this, each block in the flowcharts or block diagrams may represent a module, a program segment or a portion of the code. The module, the program segment or the portion of the code includes one or a plurality of executable instructions for implementing specified logic functions. It should be noted that in some alternative implementations, the functions specified in the blocks may also be implemented in a sequence different from that specified in the accompanying drawings. For example, two continuous blocks may be practically performed substantially parallelly, and sometimes may be performed in a reverse sequence, which depends on the involved functions. It should also be noted that each block in the block diagrams and/or flowcharts and a combination of the blocks of the block diagrams and/or flowcharts may be implemented by using a dedicated hardware-based system for implementing the specified functions or operations, or may be implemented by using a combination of dedicated hardware and computer instructions. The numbering of the various steps herein is for convenience of description and reference only, and is not intended to limit the order thereof. The specific execution order is determined by the technology itself, and a person skilled in the art may determine various permissible and reasonable orders based on the technology.

It is to be noted that the use of step numbers (e.g., alphabetic or numeric labels) in the present disclosure to designate specific method steps is merely for the convenience and clarity of description, and is by no means intended to limit the sequence of these method steps. A person skilled in the art would understand that the sequence of the relevant method steps should be determined by the technology itself and should not be unduly limited by the presence of such numbering. A person skilled in the art may determine various permissible and reasonable sequences of steps based on the technology itself.

A person skilled in the art would understand that the above technical solutions may be freely combined and superimposed as long as no conflicts exist.

It should be understood that the above embodiments are only exemplary, and construe no limitations. Under the circumstance of not departing from the basic principles of the present disclosure, various obvious or equivalent modifications or substitutions that persons skilled in the art may derive to the above-described details are all included within the scope of the claims of the present disclosure.

**Claims**

1. A frequency sweeping method for a hash board, comprising:

   S100, applying an initial voltage to the hash board to power on the hash board, and controlling chips in all chip domains to operate at a target frequency;
   S200, switching each of the chips to a SPAT mode while maintaining the chip at the target frequency, and progressively reducing a voltage of the hash board; calculating a nonce response rate of the chip; and in a case where the nonce response rate of the chip is less than a predetermined threshold, determining a previous voltage level corresponding to the nonce response rate as a limit voltage of the hash board under the target frequency;
   S300, maintaining each of the chips at the limit voltage, and calculating a frequency adjustment function of the hash board, such that operating frequencies of the chip domains from an air inlet to an air outlet of the hash board linearly increase from low to high; and
   S400, setting the operating frequency of each of the chip domains based on the frequency adjustment function, such that the chip domain at the air inlet has a lowest frequency, the chip domain at the air outlet has a highest frequency, and an average operating frequency of the entire hash board is equal to the target frequency.

2. The method according to claim 1, wherein the target frequency is a product of an initial voltage of each of the chip domains and a number of the chip domains.

3. The method according to claim 1, wherein the voltage of the hash board is progressively decreased based on a first predetermined step and a first predetermined period.

4. The method according to claim 1, wherein the frequency adjustment function is:

$$f_n = a * n + b$$

wherein

   $n$ represents a serial number of the chip domain, $n$ = 1, 2 ......N, N being a number of the chip domains;
   $f_n$ represents the operating frequency of an $n^{th}$

$$a = \frac{f_T - b}{N/4}$$

chip domain;                                    , $f_T$ being the target frequency; and
   an initial value of $b$ is $f_T$; the value of $b$ is progressively decreased based on a second predetermined step; each of the chips is switched to the SPAT mode; the nonce response rate of each of the chips is calculated and a final value of $b$ is obtained until the nonce response rate is less than the predetermined threshold or the value of $b$ is not less than a minimum operating frequency of the chip and is minimal; and in a case where the nonce response rate is less than the predetermined threshold, the value of *b* is a previous-level value of *b* of the value of *b* corresponding to the nonce response rate that is less than the predetermined threshold.

5. A computer-readable storage medium, storing one or more programs; wherein the one or more programs, when loaded and run by a processor, cause the processor to perform the method as defined in any one of claims 1 to 4.

6. A hash board, configured to implement setting of operating frequencies of chips in the hash board by using the method as defined in any one of claims 1 to 4.

7. A digital credential processing device, comprising the hash board as defined in any one of claim 6.

8. A frequency sweeping apparatus for a hash board, comprising: a target frequency setting module, a voltage adjusting module, a frequency adjustment function calculating module, and a frequency setting module; wherein

the target frequency setting module is configured to apply an initial voltage to the hash board to power on the hash board, and control chips in all chip domains to operate at a target frequency; the voltage adjusting module is configured to switch each of the chips to a SPAT mode while maintaining the chip at the target frequency, and progressively reduce a voltage of the hash board; calculate a nonce response rate of the chip; and in a case where the nonce response rate of the chip is less than a predetermined threshold, determine a previous voltage level corresponding to the nonce response rate as a limit voltage of the hash board under the target frequency; the frequency adjustment function calculating module is configured to maintain each of the chips at the limit voltage, and calculate a frequency adjustment function of the hash board, such that operating frequencies of the chip domains from an air inlet to an air outlet of the hash board linearly increase from low to high; and the frequency setting module is configured to set the operating frequency of each of the chip domains based on the frequency adjustment function, such that the chip domain at the air inlet has a lowest frequency, the chip domain at the air outlet has a highest frequency, and an average operating frequency of the entire hash board is equal to the target frequency.

9. The apparatus according to claim 8, wherein the voltage adjusting module is configured to progressively decrease the voltage of the hash board based on a first predetermined step and a first predetermined period.

10. The apparatus according to claim 8, wherein the frequency adjustment function is:

$$f_n = a*n + b$$

wherein

$n$ represents a serial number of the chip domain, $n = 1, 2 \ldots N$, N being a number of the chip domains;
$f_n$ represents the operating frequency of an $n^{th}$

$$a = \frac{f_T - b}{N\!\big/4}$$

chip domain;                     , $f_T$ being the target frequency; and
an initial value of *b* is $f_T$; the value of *b* is progressively decreased based on a second predetermined step; each of the chips is switched to the SPAT mode; the nonce response rate of each of the chips is calculated and a final value of *b* is obtained until the nonce response rate is less than the predetermined threshold or the value of *b* is not less than a minimum operating frequency of the chip and is minimal; and in a case where the nonce response rate is less than the predetermined threshold, the value of *b* is a previous-level value of *b* of the value of b corresponding to the nonce response rate that is less than the predetermined threshold.

11. A digital credential processing device, comprising the frequency sweeping apparatus for a hash board as defined in any one of claims 8 to 10.

S100 — Applying an initial voltage to the hash board to power on the hash board, and controlling chips in all chip domains to operate at a target frequency

S200 — Switching each of the chips to a SPAT mode while maintaining the chip at the target frequency, and progressively reducing a voltage of the hash board; calculating a nonce response rate of the chip; and in a case where the nonce response rate of the chip is less than a predetermined threshold, determining a previous voltage level corresponding to the nonce response rate as a limit voltage of the hash board under the target frequency

S300 — Maintaining each of the chips at the limit voltage, and calculating a frequency adjustment function of the hash board, such that operating frequencies of the chip domains from an air inlet to an air outlet of the hash board linearly increase from low to high

S400 — Setting the operating frequency of each of the chip domains based on the frequency adjustment function, such that the chip domain at the air inlet has a lowest frequency, the chip domain at the air outlet has a highest frequency, and an average operating frequency of the entire hash board is equal to the target frequency

FIG. 1

| Target frequency setting module | → | Voltage adjusting module | → | Frequency adjustment function calculating module | → | Frequency setting module |
|---|---|---|---|---|---|---|
| 100 | | 200 | | 300 | | 400 |

FIG. 2

# EUROPEAN SEARCH REPORT

Europäisches
Patentamt
European
Patent Office
Office européen
des brevets

**Application Number**

EP 25 19 0451

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2023/169595 A1 (FRESA MARC [US]) 1 June 2023 (2023-06-01) | 1-3,5-9, 11 | INV. G06F1/324 |
| A | * paragraphs [0033] - [0059]; figures 1-10 * | 4,10 | G06F1/3234 G06F1/3296 |
| | ----- | | |
| Y | CN 213 659 380 U (BEE COMPUTING HONG KONG CO LTD) 9 July 2021 (2021-07-09) | 1-3,5-9, 11 | |
| A | * paragraphs [0001] - [0033]; figure 1 * ----- | 4,10 | |

**TECHNICAL FIELDS SEARCHED (IPC)**

G06F

The present search report has been drawn up for all claims

| Place of search | Date of completion of the search | Examiner |
|---|---|---|
| The Hague | 12 November 2025 | de Biolley, Luc |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 19 0451

This annex lists the patent family members relating to the patent documents cited in the above-mentioned European search report.
The members are as contained in the European Patent Office EDP file on
The European Patent Office is in no way liable for these particulars which are merely given for the purpose of information.

12-11-2025

| Patent document cited in search report | | Publication date | Patent family member(s) | | Publication date |
|---|---|---|---|---|---|
| US 2023169595 A1 | | 01-06-2023 | CA | 3156916 A1 | 05-02-2023 |
| | | | CA | 3225230 A1 | 05-02-2023 |
| | | | US | 2023037377 A1 | 09-02-2023 |
| | | | US | 2023169595 A1 | 01-06-2023 |
| | | | US | 2025014110 A1 | 09-01-2025 |
| | | | US | 2025322462 A1 | 16-10-2025 |
| CN 213659380 U | | 09-07-2021 | NONE | | |

EPO FORM P0459

For more details about this annex : see Official Journal of the European Patent Office, No. 12/82